Europäisches Patentamt

European Patent Office

Office européen des brevets

(19)

(11) **EP 0 877 470 A2**

(12) **EUROPÄISCHE PATENTANMELDUNG**

(43) Veröffentlichungstag:
**11.11.1998 Patentblatt 1998/46**

(51) Int. Cl.⁶: **H02M 5/257**

(21) Anmeldenummer: **98107788.6**

(22) Anmeldetag: **29.04.1998**

(84) Benannte Vertragsstaaten:
**AT BE CH CY DE DK ES FI FR GB GR IE IT LI LU MC NL PT SE**
Benannte Erstreckungsstaaten:
**AL LT LV MK RO SI**

(30) Priorität: **05.05.1997 DE 19718814**
**05.05.1997 DE 29707902 U**

(71) Anmelder: **Kurz, Gerhard**
**D-75382 Althengstett (DE)**

(72) Erfinder: **Schulz, Detlef**
**72657 Altenriet (DE)**

(74) Vertreter:
**Otte, Peter, Dipl.-Ing.**
**Otte & Jakelski**
**Patentanwälte,**
**Mollenbachstrasse 37**
**71229 Leonberg (DE)**

(54) **Verfahren und Vorrichtung zur Leistungssteuerung von an ein Wechselspannungs-Versorgungsnetz angeschlossenen elektrischen Verbrauchern**

(57)    Verfahren zur Leistungssteuerung von an eine Wechselspannung angeschlossenen elektrischen Verbrauchern, insbesondere ohmschen Lasten wie Heizplatten, Gebläse, Heißluftgebläse, Elektroheizungen u.dgl., wobei in Reihe mit dem Verbraucher ein für Wechselspannung in beiden Richtungen leitendes elektrisches oder elektronisches Schaltungselement, vorzugsweise Triac, geschaltet wird und durch den vorgegebenen Winkel des Phasenanschnitts die Leistungssteuerung am Verbraucher erfolgt, dadurch gekennzeichnet, daß parallel zum ersten Reihenschaltelement (Triac TC) ein weiteres elektrisches oder elektroniscbes Schaltungselement (TD) angeordnet wird, welches jedoch als erstes zum durch die Gerätesteuerung (GS) bestimmten Triggerzeitpunkt kontrolliert leitend gesteuert wird und wobei dessen Stromfluß spätestens bei Erreichen eines vorgegebenen Schwellenstroms durch die Last (RL) oder einer Schwellenspannung an Last oder Triac von dem ersten Schaltungselement im wesentlichen übernommen wird.

Fig. 1

EP 0 877 470 A2

## Beschreibung

### Stand der Technik

Die Erfindung geht aus von einem Verfahren zur Leistungssteuerung von an ein Wechselspannungs-Versorgungsnetz angeschlossenen elektrischen Verbrauchern nach dem Oberbegriff des Anspruchs 1 bzw. von einer Vorrichtung zur Leistungssteuerung von elektrischen Verbrauchern zur Durchführung dieses Verfahrens nach dem Oberbegriff des Anspruchs 5.

Vorrichtungen zur Leistungssteuerung von elektrischen Verbrauchern, die an eine Wechselspannung, üblicherweise die Netzspannung angeschlossen sind, sind in vielfältiger Form bekannt und umfassen zumeist eine Phasenanschnittschaltung, durch welche sich der Zündwinkel der dem Verbraucher zugeführten elektrischen Wechselgröße in gewünschter Weise verstellen läßt, wodurch die zugeführte Leistung geregelt werden kann.

Bekannt sind solche Phasenanschnittsteuerungen beispielsweise aus der DE 33 03 126 C2, die eine Vorrichtung zur Einschaltstrombegrenzung bei einer mit einer Phasenanschnittsteuerschaltung versehenen Motorsteuerung für den Antriebsmotor eines Staubsaugers betrifft, sowie beispielsweise aus der DE 43 27 070 C1, in welcher eine Vorrichtung zur Regelung der Leistungsaufnahme eines Staubsaugers beschrieben ist, bei welcher über eine Phasenanschnittschaltung die dem den Staubsauger antreibenden Elektromotor zugeführte Wechselspannung auf einen solchen Wert geregelt wird, daß dieser dem Effektivwert der Motorspannung entspricht. Die dabei jeweils verwendeten Phasenanschnitt-Steuerschaltungen enthalten üblicherweise einen Triac, der in Reihe mit dem elektrischen Verbraucher, in diesem Falle also Elektromotor, ans Netz geschaltet ist und den Elektromotor mit einer lückenden (Sinus)Spannung versorgt, je nach gewünschter Leistung.

Geht man von einer aus diskreten Bauelementen aufgebauten Schaltung für den Phasenanschnitt aus, wobei hier allerdings beliebig hoch integrierte Realisierungsmöglichkeiten bis zur reinen Mikroprozessorsteuerung denkbar und möglich sind, dann umfaßt die Phasenanschnittsteuerung im Ansteuerkreis für den Triac einen üblicherweise als Potentiometer oder Trimmer einstellbaren Widerstand sowie einen Ladekondensator zur Zündung des Triacs je nach eingestelltem Widerstand, so daß durch entsprechende Verschiebung des Zündwinkels praktisch beliebige Zwischenleistungen bis zum Vollwinkel auf Wunsch abrufbar sind.

Ein sich stets ergebendes und seit kurzem verstärkt in den Blickwinkel gelangtes Problem bei solchen Phasenanschnittschaltungen besteht aber darin, daß auch bei vergleichsweise geringen Lasten dann, wenn diese im wesentlichen ohm'sch reagieren, aber auch allgemein bei immer höher ausgelegten möglichen Maximalleistungen des elektrischen Verbrauchers - wobei im folgenden zum besseren Verständnis auf die Leistung eines elektrischen Heizgerätes beispielsweise abgestellt werden soll, obwohl es sich versteht, daß die Erfindung auf jeden beliebigen elektrischen Verbraucher anwendbar ist - eine Grenze mit Bezug auf die vom Verbraucher einschließlich seiner Steuerschaltung insgesamt erzeugten Oberwellen vorgegeben oder als nicht mehr akzeptabel angesehen wird. Diese Grenze läßt sich durch einfache Mittel nicht überwinden.

Allgemein entstehen Oberwellen immer dann, wenn zwischen Strom und Spannung keine Proportionalität besteht, wobei bei der Leistungssteuerung eines elektrischen Universalmotors zunächst Oberwellen hauptsächlich als ungeradzahlige Harmonische entstehen, die in erster Näherung auf die quadratische Abhängigkeit zwischen Strom und Spannung zurückzuführen sind. Oberwellen entstehen aber auch und insbesondere durch die Phasenanschnittsteuerung selbst, die im übrigen besonders dann stark ausgeprägt sind, wenn sich der Zündwinkel bei etwa 90° befindet, wenn also durch entsprechende Zündung die Stromdurchlässigkeit des Reihentriacs in etwa in der Mitte der jeweiligen Halbwelle erfolgt.

Insbesondere beim Schalten von ohmschen Lasten mit Triacs an Wechselspannungsnetzen entstehen durch die kurzen Schaltzeiten der heute gebräuchlichen und im übrigen auch nur noch erhältlichen Triacs sehr steile Stromanstiege, was zu erheblichen Oberwellenanteilen führt, wie eine Fourier-Analyse erkennen läßt. Als beispielhaft kann hierbei etwa von folgenden numerischen Werten ausgegangen werden, wobei es sich versteht, daß die Erfindung durch diese Angaben nicht eingeschränkt wird. Bei typischen Triac-Schaltzeiten von 5 μsec und Lastströmen von beispielsweise schon zwischen 10 und 15 Ampere ergeben sich Stromanstiege von mehr als 2,5 Ampere/μsec. Dies verursacht gerade im Bereich von 100 bis 300 kHz hohe Störpegel, die selbst bei Lasten von nur ca. 500 Watt schon über erlaubten Grenzen liegen.

Üblicherweise sind solche erwähnten Grenzen des zulässigen Oberwellengehalts durch staatlich regulierte Vorschriften festgelegt oder werden demnächst in entsprechende Vorschriften eingebracht. So ist der Oberwellenbereich für den europäischen Bereich durch die sogenannte EMV-Norm repräsentiert, die insofern insbesondere auch den Betrieb ohmscher Lasten in Verbindung mit Phasenanschnittsteuerungen einengt.

Der Erfindung liegt die Erkenntnis zugrunde, durch eine Verlangsamung des Stromanstiegs bei üblichen Phasenanschnittsteuerungen die Oberwellen-Strompegel entscheidend zu reduzieren.

An sich können sich hier folgende, auch für sich gesehen bekannte Möglichkeiten anbieten, indem man beispielsweise entsprechend langsame Triacs verwendet, die jedoch aus der Halbleiter-technologischen Sicht schwieriger herzustellen und zur Zeit auch nicht verfügbar sind.

Auch der Einbau einer Induktivität, die entsprechende Stomanstiege deutlich verlangsamen könnte, verbietet sich aufgrund der hier erforderlichen hohen Kosten nicht alleine wegen der erheblichen Masse der erforderlichen Spulen, sondern auch mit Bezug auf den erforderlichen Platz und das Gewicht der Induktivitäten, da bei Strömen bis zu ca. 16 Ampere, ohne daß die Induktivität in die Sättigung gelangt, Spulengrößen von mehr als >1 mH erforderlich sind. Schließlich könnte man anstelle einer einzigen zu schaltenden ohmschen Last eine größere Anzahl sukzessive nacheinander einzuschaltender Teillasten zugrunde legen, was aber ebenfalls viel Kosten und Platz benötigt, da für jede Last ein Triac erforderlich ist, mit entsprechend hohem Montageaufwand. Auch der Einsatz von Filtern und sonstigen Abschirmmaßnahmen, um die entstandenen Oberwellen nicht ins Netz gelangen zu lassen, stellt sich als teuer und aufwendig und nur für Kleinlasten als sinnvoll heraus.

Ausgehend von der eingangs genannten Erkenntnis liegt daher der Erfindung die Aufgabe zugrunde, bei einer Phasenanschnittsteuerung für elektrische Verbraucher, insbesondere wenn diese bei geringerer Leistung als ohmsche Last reagieren, dafür zu sorgen, daß sich die bei der Phasenanschnittsteuerung entwickelnden Oberwellen sich innerhalb noch akzeptierbarer bzw. zugelassener Grenzen halten.

**Vorteile der Erfindung**

Das erfindungsgemäße Verfahren und die erfindungsgemäße Vorrichtung lösen die genannte Aufgabe jeweils mit den Merkmalen des Anspruchs 1 bzw. des Anspruchs 5 und haben den Vorteil, daß bei nur sehr geringem zusätzlichen Schaltungsaufwand eine zuverlässige Möglichkeit an die Hand gegeben wird, bei elektrischen Verbrauchern, insbesondere ohmsche Verbraucher Leistung den Oberwellengehalt, der durch zugeordnete Phasenanschnittsteuerungen erzeugt wird, erheblich zu reduzieren und sicher innerhalb vorgegebener oder vorgeschriebener Grenzwerte zu halten.

Dabei ergeben sich trotz des verlangsamten Stromanstiegs zur Reduzierung des Oberwellengehalts im praktischen Gebrauch, also bei der Verwendung einer solchen Phasenanschnittsteuerung keine funktionellen Nachteile, denn bei üblichen Netzfrequenzen von beispielsweise 50 oder 60 Hz beträgt, wenn man auch hier numerische Werte zugrunde legen will, die Dauer einer Halbwelle 10 msec, während der kontrolliert langsame Einschaltstromanstieg entsprechend vorliegender Erfindung im Bereich zwischen ca. 100 bis 200 μsec üblicherweise gehalten wird. Dies ist zwar, verglichen mit den ansonsten sehr steilen Flanken bei der TriacAnschaltung von ca. 5 μsec deutlich, nämlich um mehr als eine Größenordnung länger, ist aber, verglichen mit der gesamten Halbwellendauer ohne größere Bedeutung, insbesondere auch deshalb nicht, weil es ja möglich ist, den langsameren Einschaltstromanstieg in die Zeitsteuerungsparameter der Phasenanschnittsteuerung einzubeziehen.

Im Normalfall benötigt daher eine gemäß erfindungsgemäßen Merkmalen ausgestaltete Phasenanschnittsteuerschaltung lediglich einen zusätzlichen Transistor, der in seinem eigenen Steuerkreis so ausgebildet ist, daß er bei Triggerung durch die Gerätesteuerung bei zunächst noch gesperrtem Triac mit kontrollierter Einschaltflanke hoch fährt, bis ein Maximalwert oder der Endwert des zu diesem Einschaltwinkel möglichen Laststroms erreicht ist, woraufhin auf den Triac umgeschaltet wird, der dann den Laststrom in der jeweiligen Halbwelle übernimmt, und zwar allein schon aufgrund seiner niedrigeren Sättigungsspannung, verglichen mit dem parallel geschalteten Transistor.

Es empfiehlt sich, sofort an dieser Stelle darauf hinzuweisen, daß das in der Zeichnung dargestellte, die Erfindung anhand diskreter Schaltstufen oder in ihrer Wirkungsweise angegebene Blockschaltbild sowie das die Erfindung anhand diskreter Schaltungselemente im größeren Detail beschreibende Ausführungsbeispiel die Erfindung nicht beschränkt, sondern insbesondere dazu dient, die funktionellen Grundwirkungen der Erfindung zu veranschaulichen und spezielle Funktionsabläufe in einer möglichen Realisierungsform anzugeben. Es versteht sich, daß die einzelnen Bausteine, Blöcke und diskreten Schaltungselemente in analoger, digitaler oder auch hybrider Technik aufgebaut sein können, oder auch, ganz oder teilweise zusammengefaßt, entsprechende Bereiche von programmgesteuerten digitalen Systemen, beispielsweise also Mikroprozessoren, Einzweckrechnern, digitalen oder analogen Logikschaltungen u.dgl. umfassen und bilden können. Die im folgenden angegebene Beschreibung des bevorzugten Ausführungsbeispiels der Erfindung ist daher lediglich bezüglich des funktionellen Gesamt- und Zeitablaufs, der durch die jeweiligen Blöcke und Schaltungselemente erzielten Wirkungsweise und bezüglich des jeweiligen Zusammenwirkens der durch die einzelnen Komponenten dargestellten Teilfunktionen zu verstehen, wobei Hinweise auf die einzelnen Schaltungselemente lediglich aus Gründen eines besseren Verständnisses erfolgen und nicht einschränkend zu verstehen sind.

Dabei stellen die in den Unteransprüchen aufgeführten Maßnahmen vorteilhafte Weiterbildungen und Verbesserungen der im Anspruch 1 angegebenen Erfindung dar. Besonders vorteilhaft ist die Ausbildung des parallelen Transistors zum Triac als Darlington-Transistor, der über eine Diodenbrücke, und daher in beide Richtungen schaltend, zum Triac-Element parallel liegt.

**Zeichnung**

Ausführungsbeispiele der Erfindung sind in der Zeichnung dargestellt und werden in der nachfolgenden Beschreibung näher erläutert. Es zeigen:

Fig. 1 in Form eines Blockschaltbilds vereinfacht den grundsätzlichen Aufbau eines Ausführungsbeispiels einer Phasenanschnittsteuerschaltung für eine wirksame oberwellenreduzierte Leistungssteuerung einer an ein Wechselspannungsnetz angeschlossenen Last;

Fig. 2 in Form eines Diagramms den zeitlichen Verlauf des durch die Phasenanschnittsteuerung gesteuerten und vom Verbraucher gezogenen Stroms, wobei die unterschiedlichen Einschaltflanken des Stromanstiegs erkennbar sind, und

Fig. 3 ein Ausführungsbeispiel der Erfindung in detaillierterer Darstellung.

**Beschreibung der Ausführungsbeispiele**

Der Grundgedanke der Erfindung besteht darin, mittels eines zum üblichen Triac parallel liegenden, üblicherweise elektronischen Schaltungselements mit langsamerer Anstiegsflanke bei Ansteuerung oder mit gezielt gesteuertem Stromanstiegsverhalten den Einschaltstromverlauf durch die Last zunächst (kontrolliert) gesteuert langsam auszuführen, und zwar mit einer solchen Anstiegsflanke, daß sich, selbstverständlich bezogen auf den jeweiligen Anwendungsfall, ein noch akzeptabler Wert des erzeugten Oberwellengehalts ergibt. Anschließend, also unter Vermeidung des steilen Stromanstiegs durch den ansonsten sofort aufgesteuerten Triac, übernimmt der Triac den Laststrom ganz oder zumindest zum überwiegenden Teil, wobei auch eine vollständige Abschaltung des in seiner Funktion zeitlich vorlaufenden parallelen Schaltungselements vorgenommen werden kann. Bei diesem handelt es sich zweckmäßigerweise um einen entsprechend bemessenen Leistungstransistor, der zwar mit seiner weiteren Beschaltung und einigen Steuermitteln einen zusätzlichen Platz benötigt, jedoch im Vergleich zu sonstigen Lösungen deutlich günstiger liegt bei entscheidend reduziertem Oberwellenanteil.

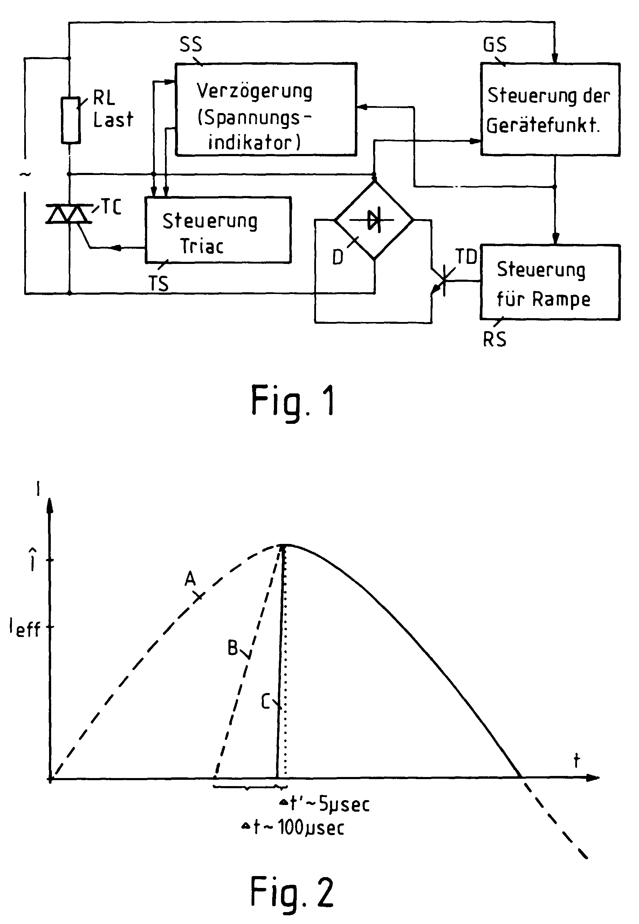

Entsprechend Fig. 1 ist eine übliche Grundsteuerung für die Gerätefunktion GS vorgesehen, die, üblicherweise aufgrund externer Vorgaben, feststellt, daß die Last zu einem vorgegebenen Winkel der Versorgungsspannung eingeschaltet werden muß und daraufhin ein entsprechendes Triggersignal ausgibt. Dieses Triggersignal wird für jede Halbwelle erzeugt und liegt über den Halbwellenverlauf bezogen an beliebiger Stelle, kann also früher oder später erfolgen, je nach dem Strom, der der Last RL zugeführt werden soll.

Anders als bei üblichen Phasenanschnittsteuerschaltungen startet das von der Grundsteuerung erzeugte Triggersignal eine Rampensteuerung RS, wobei die erzeugte Rampe einen nachgeschalteten Transistor TD kontrolliert langsam einschaltet, so daß sich eine Anstiegsflanke zum Triggerzeitpunkt von gewünscht beispielsweise zwischen 100 bis 200 µsec ergibt als Zeitverzögerung t, bis der durch den Verlauf der jeweiligen Halbwelle vorgegebene Maximalstrom durch die Last RS erreicht ist. Der Laststrom fließt dabei über einen dem Leistungstransistor TD nachgeschalteten Brückengleichrichter D, wobei der Leistungstransistor TD im Brückenquerzweig liegt. Man erkennt, daß der Brückengleichrichter D zum Reihentriac TC für die Last RL parallel liegt. Anstelle des Brückengleichrichters ist es auch möglich, zwei Transistoren jeweils mit einer Diode in Reihe zu verwenden.

Wie eingangs schon erwähnt, kann der Steuerungsverlauf, jeweils abgestimmt auf die verwendeten Schaltungselemente, in an sich beliebiger Weise erfolgen; so ist es möglich, nach Starten der Rampe eine vorgegebene Zeit abzuwarten, beispielsweise durch Ablauf einer Zählschaltung, bis auf den Reihentriac TC umgeschaltet wird, d.h. bis dieser mit seiner steilen Anstiegsflanke getriggert wird - es ist aber auch möglich, das Erreichen des Stromendwertes mittels einer weiteren Logikschaltung festzustellen, wozu dann eine Spannungssensorschaltung SS vorgesehen ist. Diese erfaßt den Spannungsabfall am Triac TC, und sobald an diesem aufgrund des Durchschaltens des Leistungstransistors TD ein vorgegebener unterer Spannungsgrenzwert erreicht ist, reagiert die Spannungssensorschaltung SS, die im Sinne einer UND-Verknüpfung auch das Triggersignal zugeführt erhält mit der Zündung des Triacs TC über die Triac-Steuerung TS. Anschließend trägt der Triac den Laststrom für die restliche Zeit, d.h. bis zur nächsten Halbwelle der Netzwechselspannung.

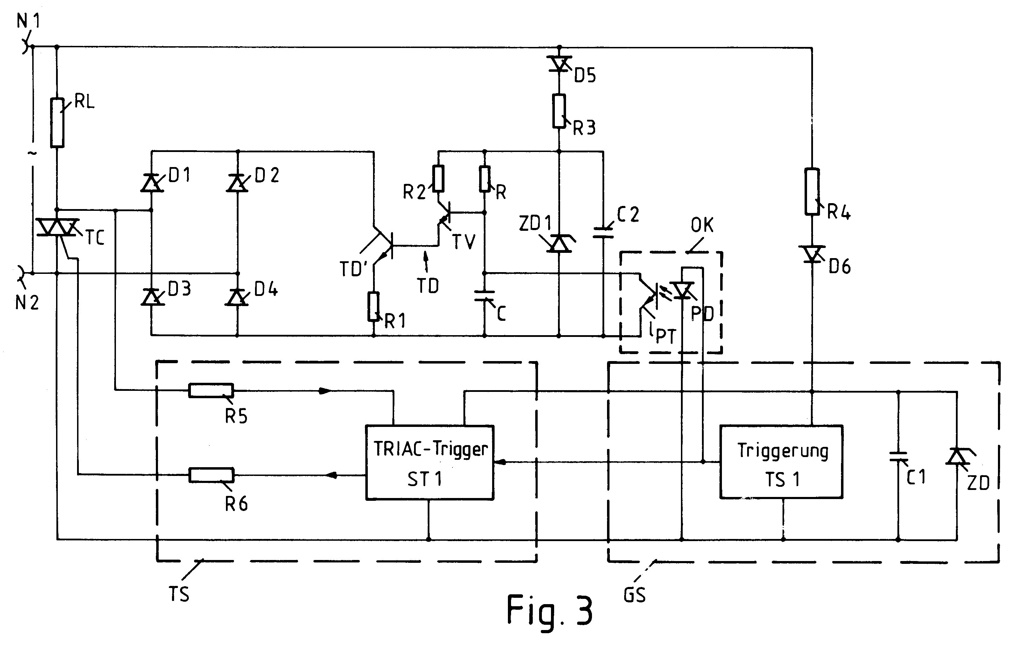

Eine solche Grundsteuerung, die darauf abstellt, daß die beiden zueinander parallel und mit der Last in Reihe liegenden elektrischen bzw. elektronischen Schaltungselemente, beim Ausführungsbeispiel der Triac TC einerseits und der parallele Leistungstransistor TD andererseits, in zeitlicher Abfolge auf die Last geschaltet werden, um so dem in seiner Anstiegsflanke langsameren Schaltungselement im Zeitpunkt der Triggerung den Vortritt zu geben, ist einer Vielzahl von Modifikationen und vorteilhaften Ausgestaltungen zugänglich, wie das Ausführungsbeispiel der Darstellung der Fig. 3 im einzelnen zeigt. Gleiche Elemente wie in Fig. 1 sind dabei mit gleichen Bezugszeichen bezeichnet; vergleichbare Schaltungsblöcke gestrichelt umrandet und ebenfalls mit den gleichen Bezugszeichen versehen.

Die bevorzugt ohmsche Last RL liegt in Reihe mit dem Triac TC an den Netzeingangsklemmen N1, N2, wobei die Triac-Steuerung TS einen bipolaren Schmitt-Trigger ST1 mit einer vorgegebenen Schaltspannungsquelle von beispielsweise ±10 Volt umfaßt. Der am Verbindungspunkt zwischen der Last RL und dem Triac erfaßte Schaltspannungswert gelangt über den Widerstand R5 auf den Schmitt-Trigger. Über den Widerstnd R6 wird der Triac vom Schmitt-Trigger geschaltet, worauf weiter unten noch eingegangen wird.

Parallel zu den Triac-Anschlußklemmen liegt die Diodengleichrichterschaltung D, bestehend aus der Diodenbrücke D1, D2, D3 und D4, mit einer Leistungstransistorschaltung im Brückenquerzweig, die aus einem Vortransistor TV als Kollektorstufe und einem nachgeschalteten Darlington-Transistor TD' besteht, mit einem Widerstand R1 im Emitterkreis. Die Grundsteuerung GS für die Gerätefunktion besteht ferner aus einer Triggerschaltung TS1 mit zugeordneten Stromversorgungselementen aus R4, D6, C1 und Zenerdiode Z3 parallel zur Triggerschaltung TS1, die auch gleich den SchmittTrigger ST1 mit Strom versorgen.

Es ergibt sich dann die folgende Funktion. Die Triggerschaltung TS1 erzeugt zum vorgegebenen Zeitpunkt das Triggersignal und führt dieses einem Optokoppler OK zu, bestehend aus der Fotodiode PD und dem Fototransistor PT. Aufgrund des Triggersignals wird der Fototransistor in seinen Sperrzustand geschaltet, so daß sich ein Ladekreis für den Kondensator C im Ansteuerkreis für den Fototransistor TV in Verbindung mit dem Widerstand R in Form eines RC-Gliedes ergibt, wobei die Spannungsversorgung über die Diode D5 in Reihe mit dem Widerstand R3 und parallel über die Zenerdiode ZD1 mit Kondensator C2 zur Stabilisierung aus dem Netz vorgenommen wird.

Hierdurch kommt es zu einem gesteuerten Stromanstieg im Bereich des Leistungstransistors TD, nämlich an der Basis des Vortransistors TV, wobei vom exponentiellen Spannungsanstieg am Ladekondensator C lediglich ein linearer Anfangsbereich (beispielsweise das erste Viertel des Kurvenverlaufs des Spannungsanstiegs am RC-Glied) ausgenützt wird. Dies bewirkt das Durchschalten des Darlington-Transistors TD', wobei die ganze Schaltung als gesteuerte Stromquelle wirkt und einen kontinuierlichen Stromanstieg über die Diodenbrücke D gewährleistet, was mit anderen Worten bedeutet, daß sich entsprechend dem Kurvenverlauf der Fig. 2 eine Anstiegsflanke B des Stroms durch die Last RL als Spiegelbild des Spannungsanstiegs über dem Kondensator C ergibt.

Dabei sind die Stromverlaufskurven entsprechend Fig. 2 wie folgt zu verstehen:

Stromverlauf A entspricht wie üblich der Formel

$$I = \frac{Uo.\sin\omega t}{R}$$

und
folgt der Netzspannung,
Stromanstieg B entspricht der gesteuerten Rampe wie soeben erläutert mit beispielsweise $\Delta t \approx 100$ µsec, und Stromanstieg C ergibt sich bei Ansteuerung des Triacs allein zu $\Delta t' \approx 5$ µsec.

Der kontinuierliche Stromanstieg so, wie er sich durch Vorabtriggerung des Leistungstransistors TD entsprechend Fig. 2 ergibt - die Darstellung der Fig. 2 zeigt die Verhältnisse natürlich dennoch stark verzerrt im eitlichen Verhältnis zur Netzhalbwelle zum besseren Verständnis -, führt zu einem entsprechenden Spannungsabfall über dem Triac TC, der über dem Widerstand R5 vom bipolaren Schmitt-Trigger ST1 erfaßt wird, der daher dann sein (nachfolgendes) Triggersignal über R6 dem Gate des Triacs TC zuleitet, wenn seine Schaltschwelle von beispielsweise ±10 Volt unterschritten wird. In diesem Moment schaltet der Triac TC durch und übernimmt aufgrund seiner wesentlich geringeren Sättigungsspannung (oder geringerem innerem Widerstand) den Laststrom vollständig, wobei es im übrigen aber auch (sinnvollerweise) zu einer Abschaltung des nunmehr lediglich noch parallel mit geringem Strom beaufschlagten Leistungstransistors TD kommt, indem, was in der Zeichnung nicht dargestellt ist, entweder das Triggersignal vom Schmitt-Trigger ST1 zum Triac gleichzeitig zur "Wiedereinschaltung" des Optokopplers OK ausgenutzt wird oder indem nach Ablauf einer vorgegebenen Zeit der Leistungstransistor in geeigneter Weise abgeschaltet wird, was sich aus dem Energieintegral über dem Transistor ergibt, damit dieser nicht überlastet wird.

## Patentansprüche

1. Verfahren zur Leistungssteuerung von an eine Wechselspannung angeschlossenen elektrischen Verbrauchern, insbesondere ohmschen Lasten wie Heizplatten, Gebläse, Heißluftgebläse, Elektroheizungen u.dgl., wobei in Reihe mit dem Verbraucher ein für Wechselspannung in beiden Richtungen leitendes elektrisches oder elektronisches Schaltungselement, vorzugsweise Triac, geschaltet wird und durch den vorgegebenen Winkel des Phasenanschnitts die Leistungssteuerung am Verbraucher erfolgt, dadurch gekennzeichnet, daß parallel zum ersten Reihenschaltelement (Triac TC) ein weiteres elektrisches oder elektronisches Schaltungselement (TD) angeordnet wird, welches jedoch als erstes zum durch die Gerätesteuerung (GS) bestimmten Triggerzeitpunkt kontrolliert leitend gesteuert wird und wobei dessen Stromfluß spätestens bei Erreichen eines vorgegebenen Schwellenstroms durch die Last (RL) oder einer Schwellenspannung an Last oder Triac von dem ersten Schaltungselement im wesentlichen übernommen wird.

2. Verfahren nach Anspruch 1, dadurch gekennzeichnet, daß das von der Grundsteuerung (GS) für die Gerätefunktion erzeugte Triggersignal einen mit vorgegebener Flanke kontrolliert hochlaufenden Stromanstieg durch das weitere Schaltungselement (TD) bewirkt, wobei zum Zeitpunkt des Erreichens des zum jeweiligen Kurvenverlauf der speisenden Netzspannung möglichen Maximalwerts des Laststroms auf das parallele erste Schaltungselement (Triac TC) umgeschaltet wird.

3. Verfahren nach Anspruch 1 oder 2, dadurch gekennzeichnet, daß die Anstiegsflankensteilheit des im Phasenanschnittzeitpunkt eingeschalteten Verbraucherstroms so bemessen wird, daß, abgestimmt auf Ausmaß der Last und Triggerzeitpunkt, jeweils minimale Oberwellenstörspannungen entstehen.

4. Verfahren nach Anspruch 3, dadurch gekennzeichnet, daß die Flankensteilheit als Funktion des Triggerzeitpunkts geändert wird.

5. Vorrichtung zur Leistungssteuerung von an ein Wechselspannungs-Versorgungsnetz angeschlossenen elektrischen Verbrauchern, insbesondere ohmschen Lasten wie Heizplatten, Gebläse, Heißluftgebläse, Elektroheizungen u.dgl., wobei in Reihe mit dem Verbraucher ein für Wechselspannung in beiden Richtungen leitendes elektrisches oder elektronisches Schaltungselement, vorzugsweise Triac, geschaltet wird und durch den vorgegebenen Winkel des Phasenanschnitts die Leistungssteuerung am Verbraucher erfolgt, dadurch gekennzeichnet, daß dem in Reihe mit der Last (RL) geschalteten Triac (TC) ein in beiden Richtungen leitendes weiteres Schaltungselement (Leistungstransistor TD) parallel geschaltet ist und daß erstes und weiteres Schaltungselement zeitlich versetzt aufeinanderfolgend so angesteuert sind, daß der Stromeinschalt-Anstiegsflankenbereich bis zu einem vorgegebenen Schwellenwert des Stroms durch die Last von dem weiteren Schaltungselement geführt ist, während der restliche Stromfluß bis zum Abklingen der jeweiligen Halbwelle über das erste Schaltungselement (Triac TC) fließt.

6. Vorrichtung nach Anspruch 5, dadurch gekennzeichnet, daß eine Rampensteuerung (RS) vorgesehen ist, die bei Eingang des Triggersignals von der Grundsteuerung für die Gerätefunktion eine Zeitschaltung ansteuert, die den Stromfluß durch das weitere Schaltungselement unter Bildung einer gesteuerten Stromquelle kontrolliert hochlaufen läßt mit vorgegebener Anstiegsflanke bis zur Übernahme des Laststroms durch das parallele erste Schaltungselement (Triac TC).

7. Vorrichtung nach Anspruch 5 oder 6, dadurch gekennzeichnet, daß die Rampensteuerung (RS) ein Zeitglied (RC-Glied) umfaßt im Steuerkreis eines Vortransistors (TV) zu einem nachgeschalteten Darlington-Leistungstransistor (TD'), dessen Ausgänge im Querzweig einer Gleichrichter-Diodenbrücke (D1, D2, D3, D4) liegen, deren andere Anschlußpunkte mit den beiden Anschlüssen des Triacs verbunden sind.

8. Vorrichtung nach einem der Ansprüche 5 bis 7, dadurch gekennzeichnet, daß eine Spannungssensorschaltung zur nachfolgenden Triggerung des als erstes Schaltungselement ausgebildeten Triacs (TC) vorgesehen ist, die den Spannungsabfall über dem Triac (TC) erfaßt und bei Unterschreiten vorgegebener Grenzwerte in beiden Richtungen den Triac (TC) zur Stromübernahme durch die Last triggert.

9. Vorrichtung nach Anspruch 8, dadurch gekennzeichnet, daß nach Stromentnahme durch den Triac der zum Triac (TC) parallele Leistungstransistor (TV, TD') abgeschaltet oder spätestens nach Zeitablauf in Abhängigkeit zum Engerieintegral über dem Leistungstransistor gesperrt wird.

10. Vorrichtung nach einem der Ansprüche 1 bis 9, dadurch gekennzeichnet, daß die Triac-Steuerung (TS) einen bipolaren Schmitt-Trigger (ST1) umfaßt, der im Sinne eines UND-Glieds nach Eingang des Triggersignals für die Ansteuerung des Leistungstransistors das nachfolgende Unterschreiten des Spannungsschwellwerts am Triac (TC) in beiden Schaltrichtungen erfaßt und daraufhin das nachfolgende Triggersignal für den Triac erzeugt.

Fig. 1

Fig. 2

Fig. 3

EP 0 877 470 A2